# EUROPEAN PATENT APPLICATION

(11) **EP 4 462 475 A1**
(43) Date of publication of application: **13.11.2024**
(21) Application number: 23172894.0
(22) Date of filing: 11.05.2023
(51) Int. Cl.: H01L 23/04, H01L 23/10, B81B 7/00, H01L 23/053, H01L 23/055, H01L 21/50, H01L 21/48

(54) **A PACKAGED SEMICONDUCTOR DEVICE AND METHOD OF MANUFACTURING THE SAME**

(71) Applicant: NXP USA, Inc., Austin TX 78735 (US)
(72) Inventor: SHAH, Ankur Shailesh, 5656AG Eindhoven (NL); DANIELS, Dwight Lee, 5656AG Eindhoven (NL); HAYES, Scott M, 5656AG Eindhoven (NL)
(74) Representative: Hardingham, Christopher Mark

(57) **Abstract**

A packaged semiconductor device (200) is disclosed, having a first major surface (210), a second major surface (220), and sidewalls (230) therebetween, the packaged device comprising: a moulding compound (240) around a perimeter of the device and defining at least a part of the sidewalls; a lid (250) defining the first major surface, and defining a cavity (252) within the packaged semiconductor device; wherein the lid extends from a central region, to and beyond an upper surface of the moulding compound, and comprises a lip (260) around at least part of the moulding compound; further comprising an adhesive material (270), between a top surface of the moulding compound and the lid and providing a bond therebetween. Related methods are also disclosed.

## Description

### Field

The present disclosure relates to packaged semiconductor devices and methods of manufacture thereof. Without being limited thereto, it is of particular significance for semiconductor packages having a cavity therein, such as, again without limitation, sensor devices or MEMS sensors for measurement of pressure, motion, acceleration and the like.

### Background

A method to provide packaged semiconductor devices which include a cavity within the device is to have sidewalls of a moulding compound around the perimeter of the package and a cavity or space within. The cavity may conveniently be created by a process such as film assisted moulding in which the outer sidewalls are formed from moulding compound whilst a film is used to prevent the moulding compound from completely filling the space within the outer sidewalls. This results in an open package in which one or more semiconductor die are located, surrounded by the sidewalls. The skilled person will also be familiar with other methods to provide the open package. After the open package has been manufactured the packaging process is typically completed by a lid attach process. Typically, the lid is a flat plate and is attached to the moulding compound of the sidewalls by means of an adhesive layer therebetween. A lid attached by such means may be prone to slippage, or poor adhesion.

### Summary

According to a first aspect of the present disclosure, there is provided a packaged semiconductor device, having a first major surface, a second major surface, and sidewalls therebetween, the packaged device comprising: a moulding compound around a perimeter of the device and defining at least a part of the sidewalls; a lid defining the first major surface, and defining a cavity within the packaged semiconductor device; wherein the lid extends from a central region, to and beyond an upper surface of the moulding compound, and comprises a lip around at least part of the moulding compound; further comprising an adhesive material, between a surface of the moulding compound and the lid and providing a bond therebetween. Including a lip may assist in locating the lid with respect to the device. It further may assist in promoting adhesion between the lid and the device by providing additional surface area for bonding between the lid and the moulding compound. The surface of the moulding compound may be a top surface of the moulding compound. The surface of the moulding compound may include the top surface of the moulding compound. It may include an upper part of sidewalls of the moulding compound. In other embodiments, the adhesive may be provided on the surface of the moulding compound, and may flow to an upper part of the sidewalls during the affixing of the lid to the moulding compound.

According to one or more embodiments, the lid has one or more through-holes to the cavity (280).

According to one or more embodiments, the lip extends around the moulding compound around an entire perimeter of the device. In other embodiments, the lip may extend around only a part of the perimeter of the device. In particular it may extend around the perimeter on only one or two sides of the device; alternatively or in addition, it may extend around the perimeter along the entirety of a side of the device or only on a part of a side of the device. In particular, in some embodiments it may be simpler to manufacture the lid if the lip does not extend around the moulding compound at corners of the device. This may be the case, for example and without limitation, in embodiments in which the lid is manufactured from a sheet material, such as a metal, and formed into shape. In such embodiments, the lid may extend outwardly beyond the moulding compound only in area where there is a lip.

According to one or more embodiments, the packaged semiconductor device further comprises: a leadframe defining at least part of second major surface and comprises a die flag, and a plurality of contact pads around the perimeter of the device; and packaged semiconductor device further comprises further moulding compound therebetween. Nonlimiting examples of such embodiments may include the package type generally known as QFN ("quad flat no-lead"). In other embodiments, a semiconductor die is mounted directly onto leads, such that a die flag is not present. In yet other embodiments, the packaged semiconductor device may further comprise a laminate substrate.

According to one or more embodiments, the lid comprises metal. A metal lid may provide enhanced shielding, and may be suited to stamping and forming as discussed above. According to one or more other embodiments, the lid comprises a plastic material. A plastics material lid may be suited to manufacture as an array and then being singulated as part of singulation of a finished packaged semiconductor device.

According to one or more embodiments, the lip extends around the moulding compound to the plurality of contact pads. According to such embodiments, the height of the lip may correspond to the height of the moulding compound forming sidewalls of the device. However generally the lip will not be full height of the device, since generally there may be provided electrical contacts around a bottom part of the perimeter of the sidewalls. This is particularly the case for package types such as QFN.

According to one or more embodiments, at least one of the sidewalls of the packaged semiconductor device is stepped. Providing stepped sidewalls, and in particular providing them such that the lip around at least part of the moulding compound and forming the sidewalls adjacent to the first major surface extends outwardly beyond the moulding compound which forms a remainder of the sidewalls, may facilitate simple assembly. For example a lid may simply be positioned or placed over the moulding compound at the sidewalls which may be planar.

According to one or more embodiments, at least one of the sidewalls comprise a chamfer. That is to say the full height of the sidewalls need not be perpendicular to the top and bottom surfaces. According to one or more such embodiments, the chamfer extends to a full height of the sidewalls. Providing a such chamfer over part of the full height of the sidewalls may assist in self-alignment of the lid with the open package during assembly

According to one or more embodiments, at least one of the sidewalls of the packaged semiconductor device is planar. In such embodiments, the lip around at least part of the moulding compound and forming the sidewalls adjacent to the first major surface may be coplanar with the moulding compound which forms a remainder of the sidewalls.

According to one or more embodiments, the moulding compound is recessed to a depth equal to the thickness of the lip. In one or more such embodiments, the recessed moulding compound comprises a sawn edge. A sawn edge may have a characteristic and recognisable texture which in particular may be less smooth than an edge which is a result of an injection moulding process, for example. The term "sawn edge" may refer to a characteristic appearance or finish of the edge rather than to the process by which it is formed.

According to a further aspect of the present disclosure, there is provided a method of manufacturing a packaged semiconductor device, the method comprising: providing a semiconductor die in an open package having sidewalls of moulding compound; providing an adhesive material on a surface of the moulding compound; and affixing a lid to the moulding compound by means of the adhesive material, wherein the lid includes a lip around at least a part of the moulding compound. The surface of the moulding compound may be, or may include, a top surface of the moulding compound. It may include an upper part of sidewalls of the moulding compound. In other embodiments, the adhesive may be provided on the surface of the moulding compound, and may flow to an upper part of the sidewalls during the affixing of the lid to the moulding compound.

According to one or more embodiments, the steps of providing an adhesive material on a surface of the moulding compound and affixing a lid to the moulding compound by means of the adhesive material may be concurrent. In such embodiments, the adhesive may initially be applied to or provided on the lid, and the lid with the adhesive already on it, may thereafter be affixed to the moulding compound.

According to one or more embodiments, the step of providing a semiconductor die in an open package having sidewalls of moulding compound comprises a film-assisted moulding step forming an integral array of open packages, having saw-lanes therebetween, each open package having therein at least one semiconductor die.

According to one or more such embodiments, the method further comprises, after the film-assisted moulding step, providing a slot partially through the moulding compound in each saw-lane.

According to one or more embodiments the step of affixing a lid to the moulding compound by means of the adhesive material comprises affixing an integral strip of lids including lip regions to the integral array of open packages, wherein the lip regions are inserted into the slots. Such a process may be consistent with or used in conjunction with wafer scale packaging and assembly. The adhesive may be provided in the slots. Alternatively and without limitation, the adhesive may be provided on the top surface and may flow into the slots during the affixing. Alternatively, the adhesive may be provided on the lids.

According to one or more embodiments the method further comprises singulating the packaged semiconductor devices by sawing through the lip regions in the slots and through moulding compound thereunder.

In one or more such embodiments a width of the saw-cut is no more than one third of the width of the slot.

These and other aspects of the invention will be apparent from, and elucidated with reference to, the embodiments described hereinafter.

### Brief description of Drawings

Embodiments will be described, by way of example only, with reference to the drawings, in which
FIG. 1 shows, schematically, a conventional packaged semiconductor device;
FIG. 2 shows, schematically, a packaged semiconductor device, according to one or more embodiments of the present disclosure;
FIG. 3 shows, schematically, a packaged semiconductor device, according to one or more other embodiments;
FIG. 4 shows, schematically, a packaged semiconductor device, according to one or more other embodiments;
FIG. 5 shows a perspective view of a lid according to one or more embodiments;
FIG. 6 shows a perspective view of another lid according to one or more embodiments;
FIG. 7 shows a perspective view of yet another lid according to one or more embodiments;
FIG. 8 shows part of an array of lids according to one or more embodiments, prior to attachment to the open packages and singulation of devices;
FIG. 9 shows part of an array of lids according to one or more other embodiments, prior to attachment to the open packages and singulation of devices;
FIG. 10A shows an array of part-processed packaged semiconductor devices;
FIG. 10B shows the array of part-processed packaged semiconductor devices, at a later stage of manufacturing;
FIG. 11 shows a perspective top and partial bottom view of a packaged semiconductor device according to one or more embodiments; and
FIG. 12 and FIG. 13 are flow-chart of methods according to the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

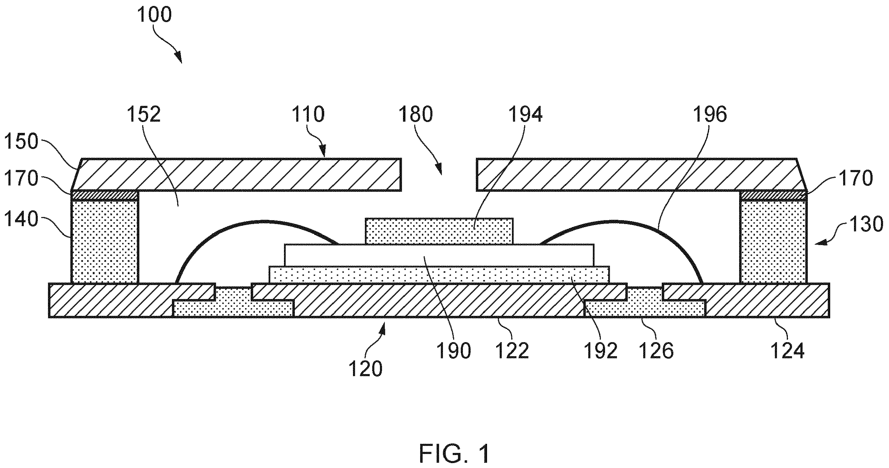

FIG. 1 shows, schematically, a conventional packaged semiconductor device 100. The device has first major surface, being a top surface 110, which is defined by a lid 150, and a second major surface, being a bottom surface 120, which in this case is defined by a lead frame having a die flag 122 in a central region and contact regions 124 round the perimeter of the packaged semiconductor device. Between the die flag 122 and the contact regions 124 is moulding compound 126. Moreover, between individual contact regions 124 there is also moulding compound, although that is not visible in this cross-section. Sidewalls 130 of the packaged semiconductor device are provided by moulding compound 140. As shown, there is an aperture 180 or hole in the lid which provides communication or between a cavity 152 within the packaged semiconductor device, and an external environment. The lid 150 is attached to moulding compound 140 at the sidewalls by means of an adhesive 170 on a top surface of the moulding compound 140. The packaged semiconductor device may include one or more semiconductor die therein. In the example shown in FIG. 1, the device includes a micro-electromechanical (MEMs) die 190 which is attached to the die flag by an adhesive 192, and has thereon a secondary die 194. Electrical prevent connection is made between the MEMs die 190 and the contact regions 124 by means of bond wires 196.

Although attaching the lid 152 to the moulding compound 140 by means of the adhesive layer on the top surface of the moulding compound 140 is relatively simple and straightforward, the seal may be prone to damage or the lid prone to peeling from the moulding compound. Moreover, the lid may be prone to lateral displacement or misalignment during the assembly process. It may also be prone to displacement or even detachment subsequently - particularly in case of a lateral force being applied, or a mechanical shock to the packaged semiconductor device.

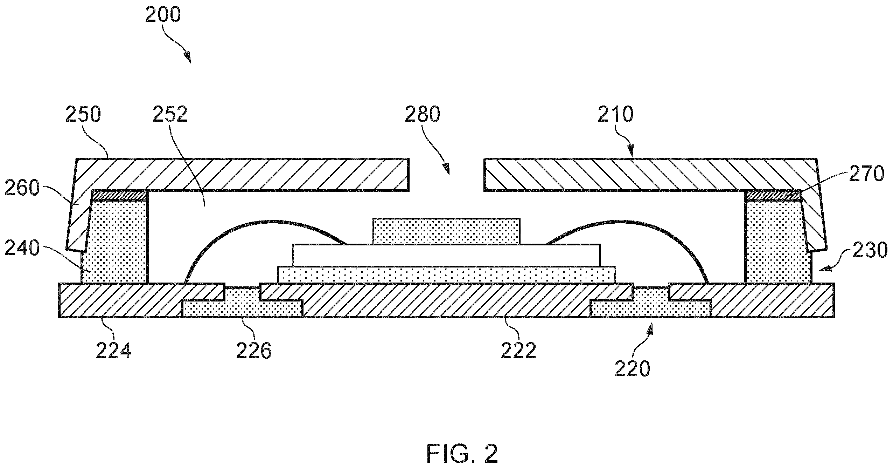

FIG. 2 shows, schematically, a packaged semiconductor device 200, according to one or more embodiments of the present disclosure. The packaged semiconductor device 200 has having a first major surface 210 which may be as shown at top surface, which is defined by a lid 250, and a second major surface 220 which may be, as shown, a bottom surface. The second major surface 220 or bottom surface may be at least partly defined by a leadframe. The lead frame may, as shown, comprise a die flag 222, and a plurality of contact pads 224 around the perimeter of the device. The die flag 222 may be located generally in a central area of the packaged semiconductor device. There may be moulding compound 226 between the die flag 222 and the electrical contacts 224. The moulding compound may provide electrical isolation between the die flag and the electrical contacts. Furthermore, there may be further moulding compound between individual electrical contacts 224. The further moulding compound may provide electrical isolation between individual electrical contacts.

The packaged semiconductor device 200 includes has sidewalls 230 between the first major surface and the second major surface. The sidewalls are at least partly defined by moulding compound around the perimeter of the device. The outer surface of the moulding compound forming at least part of the sidewalls may be perpendicular to the first and second major surfaces. In other embodiments the outer surface of the moulding compound may be at an angle to the perpendicular, as shown in FIG. 2. Typically, the outer surface of the moulding compound is within plus or minus 20° of the perpendicular, such that the packaged semiconductor device is cuboid or generally substantially cuboid. The entire sidewalls may be angled rather than perpendicular to the top and bottom surfaces semiconductor: In other embodiments only an upper or top part of the sidewalls may be angled. The sidewalls may thus be considered to include a chamfer. The chamfer may extend the full height of the sidewalls.

The packaged semiconductor device 200 includes a cavity 252 therein and generally under the lid 250. The lid extends from a central region, to and beyond an upper surface of the moulding compound. That is to say the lid overhangs, laterally, the upper surface of the moulding compound. The lid thus extends laterally beyond at least a top portion of the moulding compound. The lid comprises a lip 260 around at least a part of the moulding compound. As will be discussed in more detail hereinbelow, the lip 260 may entirely surround the moulding compound, or may be around only a part of the moulding compound. For example, the lip may extend around the moulding compound on only two of the sidewalls. Alternatively and without limitation, the lip may extend around or along only a part of some or each of the sidewalls. The lid is bonded to the moulding compound forming at least part of the sidewalls by means of an adhesive material 270 between a surface of the moulding compound and the lid. Typically, the surface of the moulding compound is the top surface; the adhesive material 270 may extend around the sidewalls or at least part of the sidewalls (not shown in FIG. 2). According to one or more other embodiments, the adhesive may be applied only to the sidewalls.

As shown, the lip extends downwards from the top surface around at least part of the sidewalls formed by moulding compound 240. Lateral movements of the lid relative to the die is thereby constrained by the lip. The lid may therefore be subject to a reduced risk of displacement or detachment in the event of, for example, a lateral mechanical shock. Moreover, the bond between the moulding compound and the lid may be enhanced. For example excess adhesive may extend downwards around the outer surface of the moulding compound during attachment of the lid and bonding process, thereby providing an enhanced or increased bonded surface area.

As shown in FIG. 2, the lip may be not exactly perpendicular to the top surface. In particular, the lip may extend downwardly outwards to some extent, although as already mentioned in general the angle will be within 20° of the vertical. Providing a downwardly outward extending lip may improve manufacturability, since it may be possible to relax the requirements on placement location accuracy, and rely on self-centring of the lid on the device as they are brought into closer contact.

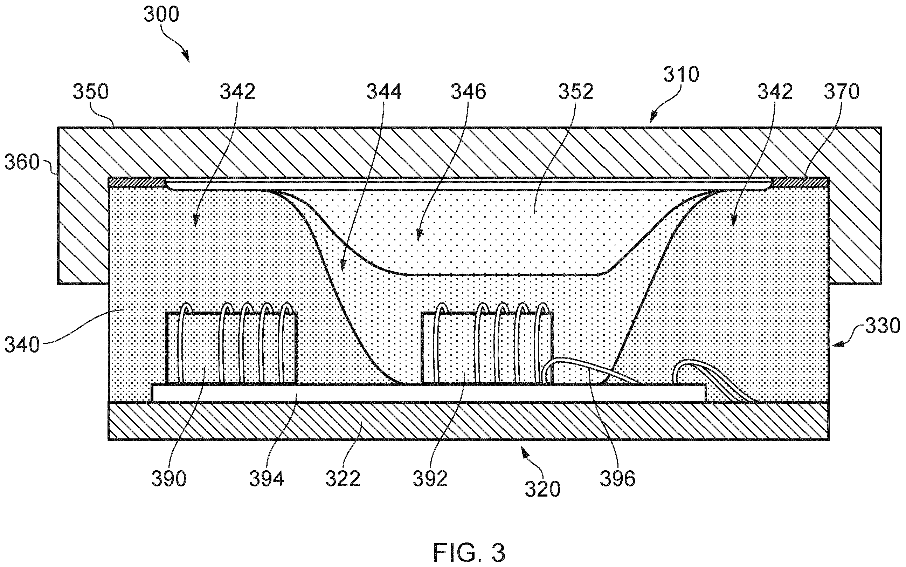

FIG. 3 shows, schematically, a packaged semiconductor device 300, according to one or more other embodiments of the present disclosure. The packaged semiconductor device 300 has a first major surface 310 which may be as shown a top surface and which is defined by a lid 350, and a second major surface 320 which may be as shown a bottom surface. The second major surface 320 or bottom surface is defined by a carrier 322.

The packaged semiconductor device 300 has sidewalls 330 between the first major surface and the second major surface. The sidewalls are at least partly defined by moulding compound around the perimeter of the device. The outer surface of the moulding compound forming at least part of the sidewalls may be perpendicular to the first and second major surfaces, as shown in FIG. 3.

The packaged semiconductor device 300 includes a cavity 352 therein and generally under the lid 250. The lid extends from a central region, to and beyond an upper surface of the moulding compound. That is to say the lid overhangs, laterally, at least part of the upper surface of the moulding compound. The lid thus extends laterally beyond at least a top portion of the moulding compound. The lid comprises a lip 360 around at least a part of the moulding compound. The lid is bonded to the moulding compound forming at least part of the sidewalls by means of an adhesive material 370 between a top surface of the moulding compound in the lid. The adhesive material 370 may extend around the sidewalls of at least part of the sidewalls (not shown in FIG. 3).

In embodiments such as that shown in FIG. 3, the cavity 352 may be provided by a film assisted moulding process. As will be familiar to the skilled person, during a film assisted moulding process, the semiconductor die assembly is first positioned within the cavity of a moulding tool. A film of a flexible material such as PTFE is pressed into contact with one or more surfaces of the die assembly. The film defines an outer region within the moulding cavity, into which moulding compound is injected. However, the film prevents moulding compound from filling the entire mould cavity, since some of it (in this case a central upper region), is protected by the film and thus inaccessible to the injected moulding compound. Once the moulding compound has set, the open package is then removed from the moulding tool, and the film removed. As a result of the film assisted moulding process, moulding compound 340 defines at least part of the sidewalls of the device in this embodiment. In the schematic cross-sectional view shown in FIG. 3, moulding compound is seen in the cross-section around the perimeter of the device and in an outer region 342. Depicted also in the FIG. is an angled interior wall 344 of the moulding compound, as originally defined by the film. Finally, the FIG. also depicts a rear interior wall 346 of the moulding compound, as this is visible in the schematic cross-sectional view.

The semiconductor die assembly may comprise one or a plurality of semiconductor die 390, 392 as shown. The, or each, semiconductor die may be directly mounted on the carrier 322, or may be mounted on a subcarrier 394 which in turn may be mounted on the carrier 322. Bond wires 396 may connect the semiconductor die to the subcarrier or to each other The semiconductor die assembly may, further, include other devices or die, such as, without limitation, integrated passive devices. The skilled person will appreciate that the present disclosure is applicable to a wide range of types of packaged semiconductor devices. Furthermore, although no aperture or hole is shown in the lid 350, the skilled person will appreciate that the 350 may, but need not, include an aperture or hole therethrough.

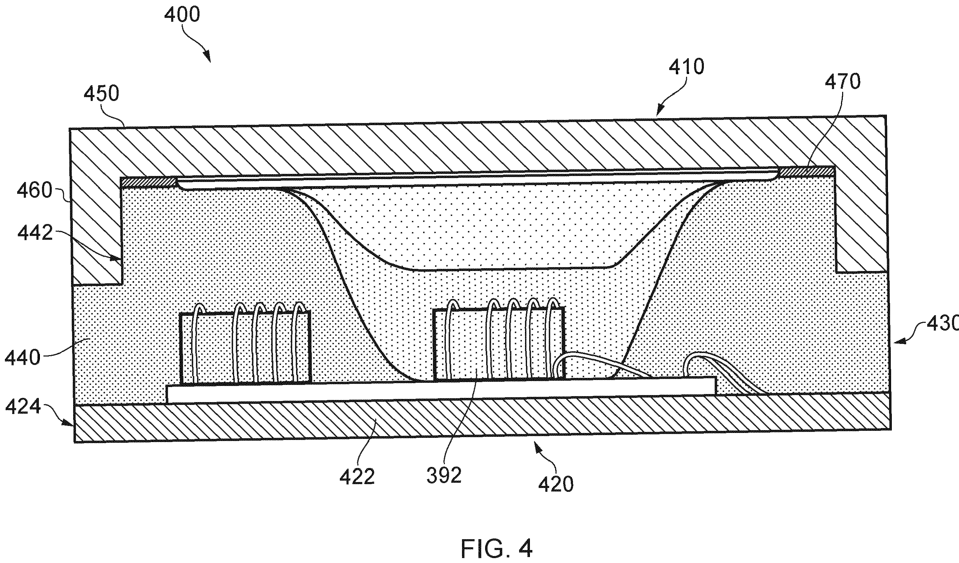

FIG. 4 shows, schematically, a packaged semiconductor device 400, according to one or more other embodiments of the present disclosure. The packaged semiconductor device 400 has a first major surface 410 which may be as shown a top surface and which is defined by a lid 450, and a second major surface 420 which may be as shown a bottom surface. The second major surface 420 or bottom surface is defined by a carrier 422.

The packaged semiconductor device 400 has sidewalls 430 between the first major surface and the second major surface. The sidewalls are at least partly defined by moulding compound 440 around the perimeter of the device. The outer surface of the moulding compound forming at least part of the sidewalls 430 may be perpendicular to the first and second major surfaces, as shown in FIG.4. In the embodiment shown in FIG. 4, a top or upper part of the moulding compound around the perimeter of the device is recessed as shown at 442. The lip 460 of the lid 450 is positioned adjacent to the recess such that the sidewalls 430 are planar. As shown the sidewalls may be vertical, that is to say perpendicular to the first second major surfaces. The lid is bonded to the moulding compound by means of an adhesive 470. In such embodiments, the lip around at least part of the moulding compound, and forming the sidewalls adjacent to the first surface, is coplanar with the moulding compound which forms a remainder of the sidewalls. In other words, the lip may in such embodiments form an upper part of the sidewalls of the packaged semiconductor device. The adhesive 470 may extend or flow around the moulding compound, and between the moulding compound and the lip (not shown).

According to one or more embodiments, the adhesive material may be an epoxy material or other suitable material for bonding the lid to the moulding compound. Moreover, according to one or more about other embodiments one or more additional layers may be included in addition to or instead of the adhesive or proxy 470 in order to provide the bond between the lid and the moulding compound forming at least part of the sidewalls.

In one or more embodiments, the lid may be positioned and affixed to the open package as a single lid being affixed to a single package. Alternatively, in one or more other embodiments an array of lids may be fixed to an array of packages in a single operation, as will be discussed in more detail hereinbelow. In such embodiments, the individual lids and packages may be singulated after the array of lids is fixed to the array of packages. Singulation may be carried out by a sawing operation. In such embodiments the sidewalls 430, comprising an upper part being the lip 460 of the lid 450 and a lower part being the moulding compound 440, may have a surface finish corresponding to a sawn edge. In some such embodiments, a lowermost part of the sidewalls may be formed of a side face 424 of the carrier 422.

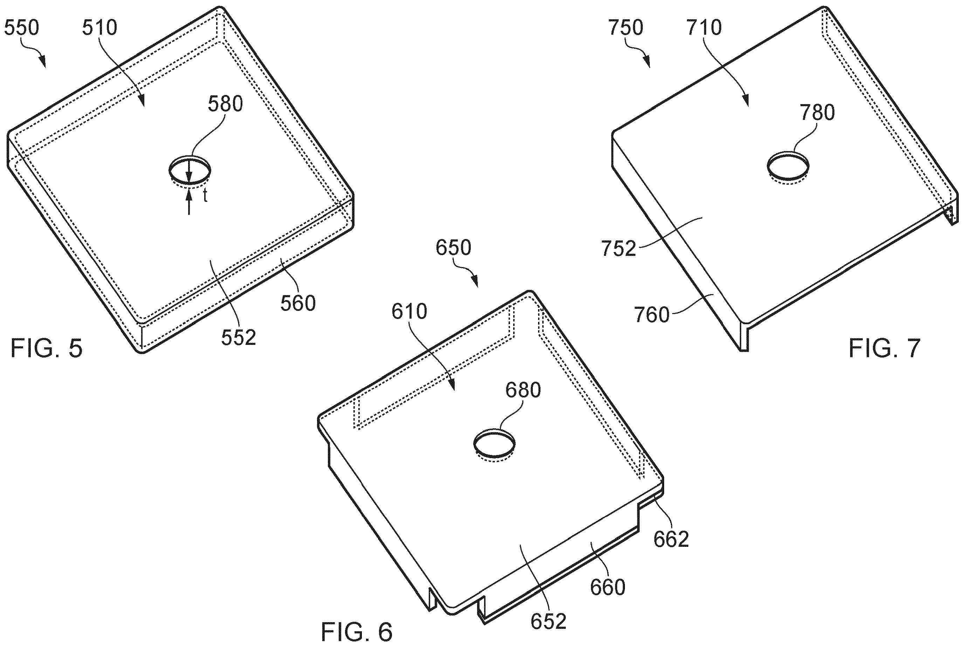

FIG. 5 shows a perspective view of a lid 550 according to one or more embodiments. Although any of a variety of materials or composites may be beneficially used as the material for the lid, in many applications a metal or metal composite may be most appropriate. In other applications a material chosen from one of the groups of plastic materials, including but not limited to polypropylene, polystyrene, polyvinyl chloride and the like, may be most appropriate. The lid 550 has an upper surface 510, and includes a top plate 552 having a thickness t. The thickness t may be in a range of 100 to 500 µm. The top surface of the lid 550 may typically be flat or planar. Lid 550 further includes a lip or walls 560. The thickness of the walls may be the same as the thickness t of the top plate or may be different. The lid 550 may have a through hole or aperture 580 through the top plate. In embodiments in which the lid does include an aperture the aperture may be essentially located offset. In other embodiments (not shown) the lid may include a plurality of such apertures.

As shown in the embodiment depicted in FIG. 5, the lip may be around the entire perimeter of the top plate of the lid. In use, such a lip is around the entire perimeter of the moulding compound which forms the sidewalls of the packaged semiconductor device.

Lids according to other embodiments of the present disclosure are shown in FIG. 6 and FIG. 7. In each of these embodiments, the lip does not go around the entire perimeter of the top plate of the lid. Thus, in use, the lip of these lids around only a part of the moulding compound which forms the sidewalls of the packaged semiconductor device.

FIG. 6 shows a perspective view of a first such lid 650. This lid has a top plate 652 which forms the first major surface 610 of the packaged semiconductor device in use and which may have an aperture 680 therethrough. However, in this embodiment the lip extends along only a part of each of the four sides of the lid, and is absent from corner regions 662. Such a lid may be particularly convenient to manufacture from a metal material, since a net or the lid (that is to say, a planar outline of the material required to form the lid) may be stamped from a sheet of material having thickness t, and then formed by a shaping tool providing an angle between the top plate and the parts of the net which will form the lip 660. As discussed above, the angle may typically be within the range of 70° to 90°.

FIG. 7 shows a perspective view of a second such lid 750. This lid has a top plate 752 which forms the first major surface 710 of the packaged semiconductor device in use, and which may have an aperture 780 therethrough. In this embodiment the lip 760 extends along at least a part of only two of the four sides of the lid. As shown the lip may extend along the entirety of each of the two sides, or may be absent from the corner regions (analogous to the lid shown in FIG. 6). This lid may also be easy to manufactured by a simple stamping and forming process. Alternatively other processes may be used to manufacture the lid. These include but are not limited to moulding processes such as injection moulding.

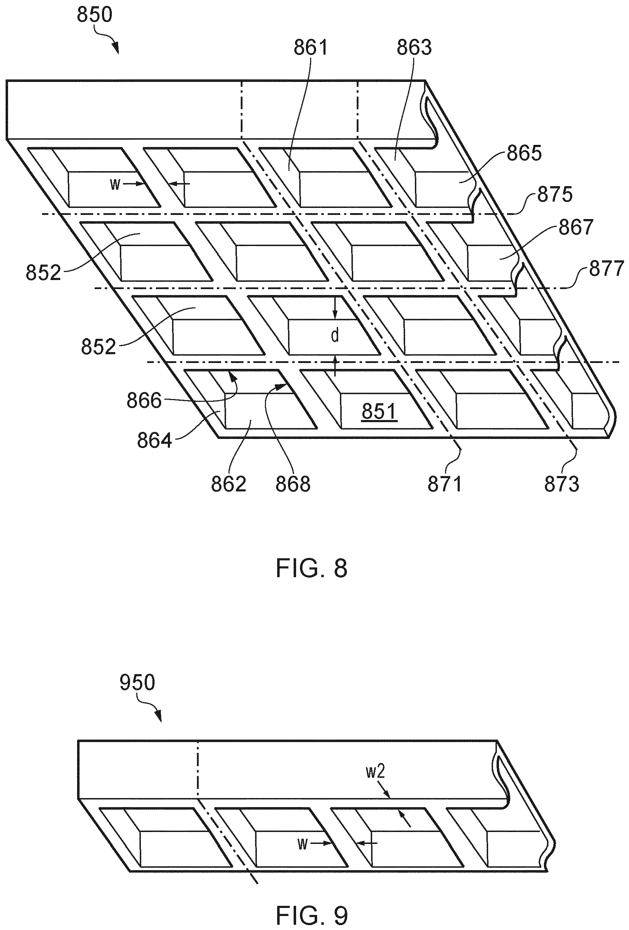

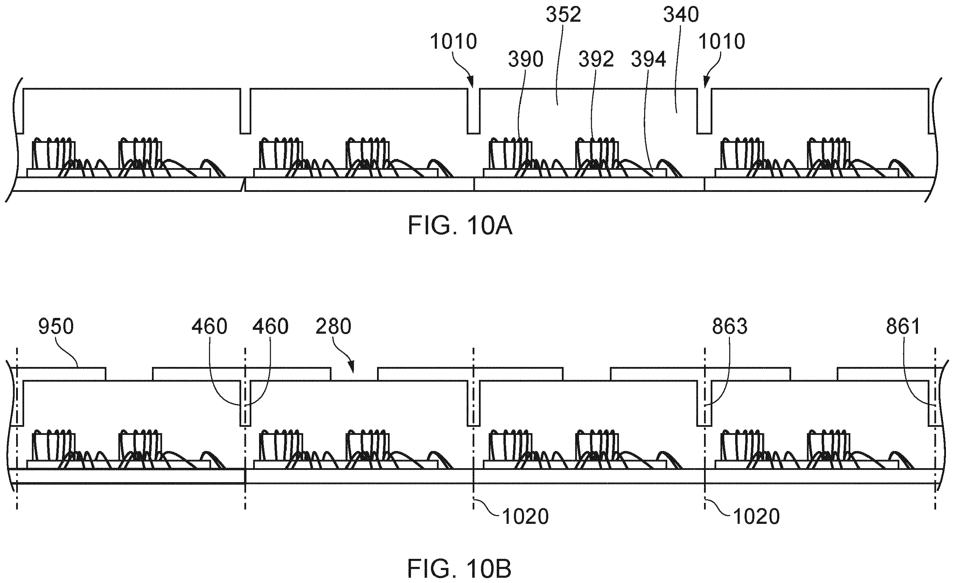

FIG. 8 shows part of an array of lids 850 according to one or more embodiments, prior to attachment to the open packages and singulation of the devices. The figure shows an "egg-box" arrangement of downwards facing lids 851, each row of the array being 4 lids wide, and 3 1/2rows of lids are shown. An individual lid 851 forming part of the array has lips on its sidewalls 862, 864, 866 and 868. The under-surface 852 of the top plate of the individual lids is visible, as are bars 861, 863 etc. in one direction, and 865, 867 et cetera in a perpendicular direction. After assembly onto open packages, to form a connected array of packaged semiconductor devices, the devices including the lids shown are singulated by sawing sawcut 871, 873... along the middle of the bars 861, 863 etc... in one direction, and sawcuts 875, 877 etc. along the middle of bars 865, 857, etc. in the perpendicular direction. The sawing process splits bars 861, 863, ... generally in half (and at the same time removes material from the central of the bars). As will be apparent from FIG. 10B and the associated description. The typical width of the sawcut (that is to say the blade width of the saw together with the so-called kerf loss) is between 200 and 300 µm. Furthermore, the width of the lip of each semiconductor package device may in a range between 100 and 200 µm. In order to provide these dimensions, the bars in the original eggbox arrangement shown in FIG. 8 may typically have a width of 400 to 1000 µm. The depth of the bars corresponds to the depth of the eventual lip of the lid of each package semiconductor device, and may typically be of the order of 300 to 600 µm.

FIG. 9 shows part of an array of lids 950 according to one or more other embodiments, prior to attachment to the open packages and singulation of the devices. In this configuration, there is a strip of lids, the strip being the width of a single lid. The "eggbox" arrangement shown in FIG. 9 is similar to that shown in FIG. 8 except that singulation is only required in one direction. Since no singulation is required in the perpendicular direction (left - right as shown), the width of the bar, w2, in this direction corresponds directly to that of the lip of the final lid. It thus may typically be in a range of 100 to 200 µm.

FIG. 10A shows an array of part-processed packaged semiconductor devices. In particular, the FIG. shows a sectional view of a connected array of open packages, which have been formed by a film assisted moulding process whereby, for each packaged device, a semiconductor die assembly, comprising in this instance two individual die 390 and 392 mounted on a subcarrier 394, has been partially encapsulated in moulding compound 340. The encapsulation has been performed on the complete array within a single mould tool, and as a result, the individual die are connected together by a continuous sheet of moulding compound although, as discussed above, each open package includes a central region in which the moulding compound is absent and which will eventually form the cavity of that device. Subsequent to the film assisted moulding, the individual packaged devices have been partially singulated by a partial depth sawcut 1010. The depth of this partial depth sawcut 1010 corresponds to the depth of the lip of the lids, such as that shown in FIG. 9.

FIG. 10B shows the array of part-processed packaged semiconductor devices, at a later stage of manufacturing. An array of lids 950 has been attached to the array of open packages, by means of adhesive (not shown). The lids shown have an aperture 280 therethrough although as discussed above this is optional. The FIG. further shows the saw lines 1020 which will later be used to singulate the individual packaged semiconductor devices. As discussed above with respect to FIG. 8 and FIG. 9, the connected array of packaged semiconductor devices are sawn through the middle of the bars 861, 863... of the eggbox arrangement of array of lids, to singulate them. It will be appreciated that the saw lines 1020 are, narrower than the partial depth sawcut 1010. Typically the saw lines 1020 may be one third or less of the width of the partial depth sawcut 1010, in order to ensure that, after manufacturing tolerances like are taken into account, the lid for each singulated packaged semiconductor device includes a lid around each edge. However it will be appreciated that the invention is not limited to these relative widths, provided only that a lip remains on both sides of the singulation cut.

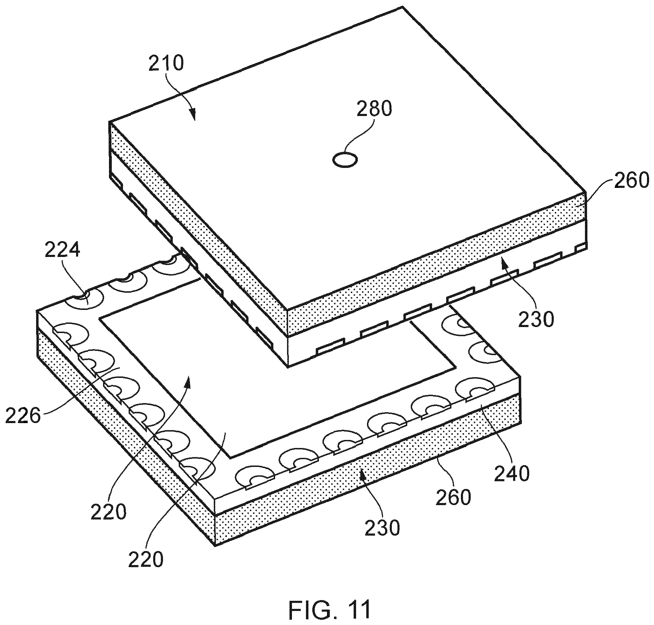

FIG. 11 shows a perspective top partial bottom view of a packaged semiconductor device according to one or more embodiments. This device is an example of a QFN (quad flat no leads package) design; however, the skilled person will appreciate that embodiments of the present disclosure are applicable to a wide range of types of package. In this QFN package, the first major surface 210 or top surface includes an aperture or through hole 280 into the cavity (not shown), and the lid 250 includes a lip 260 which in this case extends around the entire perimeter of the device and around a top (when viewed from above) portion of the moulding compound 240; the moulding compound forms a lower portion of the sidewalls 230. The second major surface 210, also referred to as the bottom surface of the device, includes a die flag 222, electrical contact regions 224, and further moulding compound 226 therebetween.

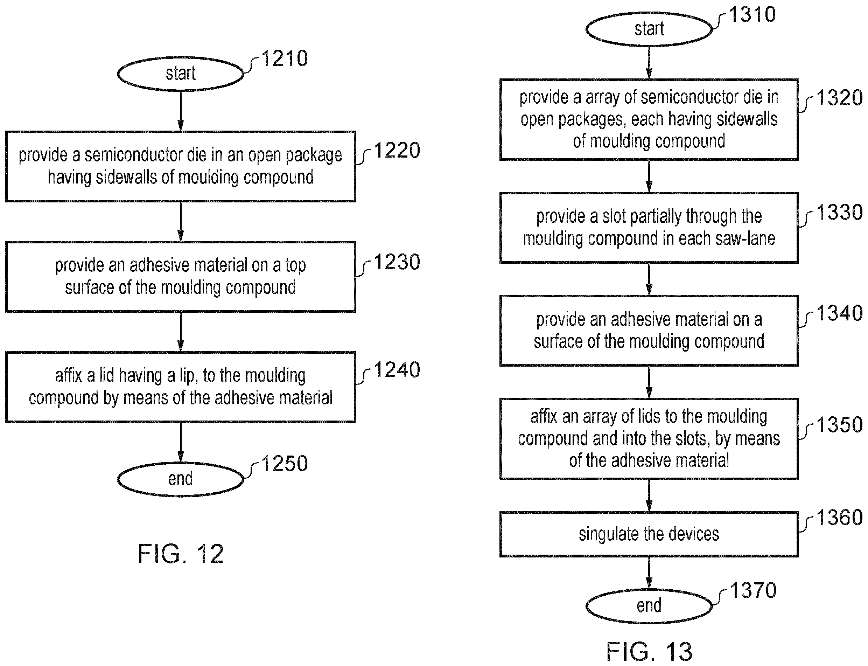

FIG. 12 shows a flowchart of a method according to the present disclosure. The method starts at 1210. Step 1220 includes providing a semiconductor die in an open package having sidewalls of moulding compound; step 1230 includes providing an adhesive material on a surface of the moulding compound; step 1240 comprises affixing a lid, having a lip around at least part of the moulding compound, on the moulding compound by means of the adhesive material. The adhesive is typically applied directly on to the top surface. It may flow into around the moulding compound. Alternatively, the adhesive may be applied to the lid. The lip is around at least part of the moulding compound, which may assist in locating the lid relative to the package and promoting adhesion as well as reducing the likelihood of detachment of the lid. The method ends at step 1250.

FIG. 13 shows a flowchart of another method according to other embodiments of the present disclosure. The method starts at 1310. Step 1320 includes providing an array of semiconductor die in open packages, each having sidewalls of moulding compound. Step 1330 includes providing a slot through the moulding compound in each saw lane between individual open packages of the array. Step 1340 includes providing an adhesive material on a surface of the moulding compound of each open package of the array. The adhesive is typically applied directly on to the top surface. It may flow into the slots, either on application, or during subsequent affixing of the lid or lids, but may, alternatively or in addition, be directly applied into the slots. Alternatively, the adhesive may be applied to the lid or array of lids. Step 1350 includes affixing an array of lids to the moulding compound and into the slots, by means of the adhesive material. It will be appreciated that the array of lids includes downwardly protruding bars which are inserted into the slots thereby locating the lids relative to the open packages. The bars are of sufficient width to enable them to be sawn down the middle, leaving material on either side to form lips of neighbouring packaged semiconductor devices. Step 1360 includes singulated and the devices by means of soaring down the middle of the bars or by other means of separation. The method ends at step 1370.

From reading the present disclosure, other variations and modifications will be apparent to the skilled person. Such variations and modifications may involve equivalent and other features which are already known in the art of packaged semiconductor devices, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to. Unless stated otherwise, terms such as "first" and "second" are used to arbitrarily distinguish between the elements such terms describe. Thus, these terms are not necessarily intended to indicate temporal or other prioritization of such elements.

## Claims

1. A packaged semiconductor device (200), having a first major surface (210), a second major surface (220), and sidewalls (230) therebetween, the packaged device comprising:
a moulding compound (240) around a perimeter of the packaged device and defining at least a part of the sidewalls;
a lid (250) defining the first major surface, and defining a cavity (252) within the packaged semiconductor device;
wherein the lid extends from a central region, to and beyond an upper surface of the moulding compound, and comprises a lip (260) around at least part of the moulding compound; and
wherein the packaged device further comprises an adhesive material (270), between a surface of the moulding compound and the lid and providing a bond therebetween.

2. The packaged semiconductor device according to claim 1, wherein the lid has one or more through-holes to the cavity (280).

3. The packaged semiconductor device according to claim 1 or 2, wherein The surface of the moulding compound is a top surface of the moulding compound.

4. The packaged semiconductor device according to any preceding claim, wherein the lip extends around the moulding compound around an entire perimeter of the device.

5. The packaged semiconductor device according to any preceding claim, further comprising:
a leadframe defining at least part of second major surface and comprises a die flag (222), and a plurality of contact pads (224) around the perimeter of the device; and
wherein packaged semiconductor device further comprises further moulding compound (226) therebetween.

6. The packaged semiconductor device according to any preceding claim, wherein the lid comprises one of metal and a plastic material.

7. The packaged semiconductor device according to any preceding claim, wherein the lip extends around the moulding compound to the plurality of contact pads.

8. The packaged semiconductor device as claimed in any preceding claim, wherein
at least one of the sidewalls of the packaged semiconductor device is stepped.

9. The packaged semiconductor device as claimed in any preceding claim, wherein
at least one of the sidewalls comprises a chamfer.

10. The packaged semiconductor device as claimed in any of claims 1 to 7, wherein
at least one of the sidewalls of the packaged semiconductor device is planar.

11. The packaged semiconductor device as claimed in claim 8, wherein
the moulding compound is recessed to a depth equal to a thickness of the lip.

12. The packaged semiconductor device as claimed in claim 11, wherein the recessed moulding compound comprises a sawn edge.

13. A method of manufacturing a packaged semiconductor device, the method comprising:
providing a semiconductor die in an open package having sidewalls of moulding compound;
providing an adhesive material on a surface of the moulding compound; and
affixing a lid to the moulding compound by means of the adhesive material,
wherein the lid includes a lip around at least a part of the moulding compound.

14. The method of claim 13, wherein the step of providing a semiconductor die in an open package having sidewalls of moulding compound comprises
a film-assisted moulding step forming an integral array of open packages, having saw-lanes therebetween, each open package having therein at least one semiconductor die.

15. The method of claim 13 or 14, further comprising providing a slot partially through the moulding compound in each saw-lane.
